Europäisches Patentamt

European Patent Office

Office européen des brevets

(19)

(11) Numéro de publication : **0 146 661**
**B1**

(12) **FASCICULE DE BREVET EUROPÉEN**

(45) Date de publication du fascicule du brevet :
**02.03.88**

(51) Int. Cl.⁴ : **G 06 F 11/26**, G 01 R 31/28

(21) Numéro de dépôt : **83430043.6**

(22) Date de dépôt : **28.12.83**

(54) **Procédé de diagnostic électrique pour identifier une cellule défectueuse dans une chaîne de cellules formant un registre à décalage.**

(43) Date de publication de la demande :
**03.07.85 Bulletin 85/27**

(45) Mention de la délivrance du brevet :
**02.03.88 Bulletin 88/09**

(84) Etats contractants désignés :
**DE FR GB**

(56) Documents cités :
**US-A- 3 761 695**
**US-A- 3 961 252**
**IEEE TRANSACTIONS ON COMPUTERS , vol. C-31, no. 1, janvier 1982, New-York, USA; T.W. WILLIAMS et al. "Design for testability - a survey", pages 2-15**
**ELECTRONICS, 15 mars 1975; N.C. BERGLUND "Level-sensitive scan design test chips, boards, system", pages 108-110,**

(73) Titulaire : **International Business Machines Corporation**
**Old Orchard Road**
**Armonk, N.Y. 10504 (US)**
**DE GB**
**Compagnie IBM FRANCE**
**5 Place Vendôme**
**F-75000 Paris 1er (FR)**
**FR**

(72) Inventeur : **Petit, Domique André Raymond**
**136, Rue Georges Le Dû Bat. D10**
**F-91100 Corbeil-Essonnes (FR)**
Inventeur : **Du Pasquier, Marc Pierre**
**6, Mail temps des Cerises**
**F-91000 Evry (FR)**

(74) Mandataire : **Klein, Daniel Jacques Henri**
**Compagnie IBM France Département de Propriété Intellectuelle**
**F-06610 La Gaude (FR)**

0 146 661

## Description

La présente invention se rapporte aux techniques de test des circuits intégrés et plus particulièrement à un procédé de diagnostic électrique permettant d'identifier une cellule défectueuse dans une chaîne de cellules formant un registre à décalage d'un élément fonctionnel ; chaque cellule consistant en une bascule statique.

On sait que l'inaccessibilité aux signaux internes et en particulier aux nœuds du réseau, constitue le principal obstacle pour tester les circuits intégrés, notamment ceux réalisés selon la technique d'intégration à grande échelle (LSI), d'un élément fonctionnel déterminé (microplaquette, module, carte ou système). Les techniques de test précédemment utilisées, mettaient en œuvre des procédures séquentielles complexes dont l'objet était de faire fonctionner tous les circuits internes et de transférer les résultats aux bornes de sortie dudit élément aux fins d'analyse.

La complexité de ces éléments fonctionnels s'étant considérablement accrue ces dernières années, ces procédés étaient devenus trop longs, et trop coûteux, voire inefficaces.

La demanderesse a donc été amenée à mettre au point dans les années 1970 une nouvelle technique de test basée sur une conception particulière des circuits, dite Level Sensitive Scan Design (LSSD), ainsi que cela ressort notamment des références US-A-3 783 254, 3 784 907, 3 806 891 et 3 961 252.

La technique LSSD permet de résoudre les problèmes de test à tous les niveaux d'éléments fonctionnels et donc finalement à tous les niveaux physiques d'une machine. Elle permet de tester complètement chaque élément fonctionnel et rend même possible le diagnostic d'un système complexe en clientèle, par un technicien de maintenance.

Par élément fonctionnel, on entend dans la présente demande essentiellement une microplaquette ou un module. Bien que l'on pourrait étendre cette notion à une carte ou encore à un système.

Les principes du test des circuits intégrés selon la technique LSSD, sont exposés dans l'article de Neil C. Berglund publié dans la revue Electronics du 15 mars 1979, pages 108-110 et intitulé : « Level-Sensitive Scan Design Tests Chips, Boards, System », et dans l'article Design for testability. A survey, par T. W. Williams et al. publié dans l'IEEE, Transactions on computer, vol. C31 n° 1, Janvier 1982, pp. 2-15.

Le niveau le plus bas est constitué par la microplaquette. On sait qu'il s'agit d'un bloc de silicium, contenant plusieurs milliers de composants élémentaires tels que transistors, diodes, résistances... interconnectés entre eux de façon à réaliser des centaines de circuits capables d'assurer les fonctions logiques désirées.

Plusieurs microplaquettes sont assemblées sur un substrat de céramique muni de broches d'entrée-sortie qui assurent les interconnections électriques avec le monde extérieur. Ce substrat est encapsulé dans un boîtier pour constituer un module.

Plusieurs modules sont à leur tour regroupés sur une carte à circuits imprimés.

Enfin, au niveau le plus élevé, plusieurs de ces cartes peuvent être associées pour constituer un système.

Une microplaquette conforme à la technique LSSD peut comporter plusieurs blocs de logique combinatoire, à chacun desquels est associée une cellule de mémoire appelée SRL (Shift Register Latch) et composée d'une paire de bascules. Les cellules sont chaînées de manière à réaliser un long registre à décalage, dit « chaîne LSSD » ; chaque cellule ou étage de la chaîne LSSD est constituée par une bascule statique, pratiquement par une paire de bascules de type bistable désignées L1 et L2.

La bascule L1 peut être positionnée à partir de deux sources par deux signaux d'horloge A et C appliqués à des entrées référencées A et C, cette dernière recevant les signaux d'horloge « système ». Cette bascule possède également une entrée de données, « Data In » (DI), et une entrée de test, dite « Scan Data In » (SDI) ; les configurations de test sont appliquées sous la forme de mots binaires à la borne d'entrée SDI générale de la microplaquette. La bascule L2 possède une entrée de données connectée à l'une des sorties de la bascule L1 associée, et une entrée qui reçoit des signaux de l'horloge B qui provoque le chargement dans L2 de la donnée disponible sur la sortie de L1.

Le long registre à décalage mentionné ci-dessus est réalisé en connectant la sortie de la bascule L2 de la première cellule (formant le premier étage) à l'entrée de la bascule L1 de la cellule suivante, et ainsi de suite, jusqu'à la dernière cellule. L'entrée de test SDI de la bascule L1 de la première cellule est connectée à la borne d'entrée SDI de la microplaquette ou entrée générale, et la sortie de la bascule L2 de la dernière cellule est reliée à une borne de sortie, dite « Scan Data Out » (SDO), de la microplaquette ou sortie générale. Les entrées d'horloge A, B et C de chaque cellule sont reliées aux bornes d'entrée de la microplaquette portant ces désignations.

Il est évident que le concept de « chaînage » peut également s'appliquer à des éléments fonctionnels de même nature ou de natures différentes.

Il est important de noter que les bascules constituant les chaînes LSSD peuvent occuper jusqu'à 40 % environ de la surface d'une microplaquette de circuits logiques ; cependant, il faut tenir compte du fait que la plupart de ces bascules, sont utilisées dans le fonctionnement normal du système.

Une information est transmise en deux étapes : à l'impulsion d'horloge A, un bit présenté sur l'entrée de test SDI de L1 est chargé dans L1 ; à l'impulsion d'horloge B, ce même bit est obtenu à la sortie de la bascule L2. Il faut autant de couples d'impulsions d'horloge A et B qu'il y a de cellules, pour qu'un signal

2

# 0 146 661

présent sur l'entrée SDI d'un ensemble fonctionnel soit disponible sur la sortie SDO dudit ensemble. Dans ce mode de fonctionnement, l'horloge C est inactive.

Lors du test d'un élément fonctionnel, on procède d'abord à un test statique appelé : FLUSH test. C'est-à-dire que l'on porte les entrées des horloges A et B au potentiel actif par exemple au potentiel haut (A = B = 1), l'entrée de l'horloge C restant inactive par exemple, elle est portée au potentiel bas (C = 0). On applique une impulsion de forme carrée sur l'entrée SDI de la chaîne à diagnostiquer, qui sera disponible sur la borne de sortie SDO de cette chaîne, avec un certain retard. Il s'agit dans ce cas d'un test statique de type combinatoire, chaque bascule formant la chaîne LSSD se comporte comme un inverseur, la chaîne LSSD ne fonctionne plus comme un registre à décalage mais comme une série d'inverseurs. Dans ces conditions, le registre à décalage transmet directement sur sa sortie SDO l'information présente sur l'entrée SDI, avec un retard égal à la somme des temps de réponse de chacune des cellules de la chaîne LSSD. En plus de fournir des indications sur les délais de propagation, ce test FLUSH peut mettre en évidence la non-fonctionnalité de la chaîne LSSD.

On procède ensuite à un test dynamique appelé SCAN test, c'est-à-dire que l'horloge C est maintenue à 0, pendant que l'on applique aux bornes A et B, une série d'impulsions (l'horloge B est décalée par rapport à l'horloge A). La chaîne LSSD fonctionne alors comme un registre à décalage. Ce test peut mettre en évidence également la non-fonctionnalité de la chaîne si la donnée présente sur l'entrée SDI n'est pas transmise à la sortie après l'application des impulsions sur les entrées A et B.

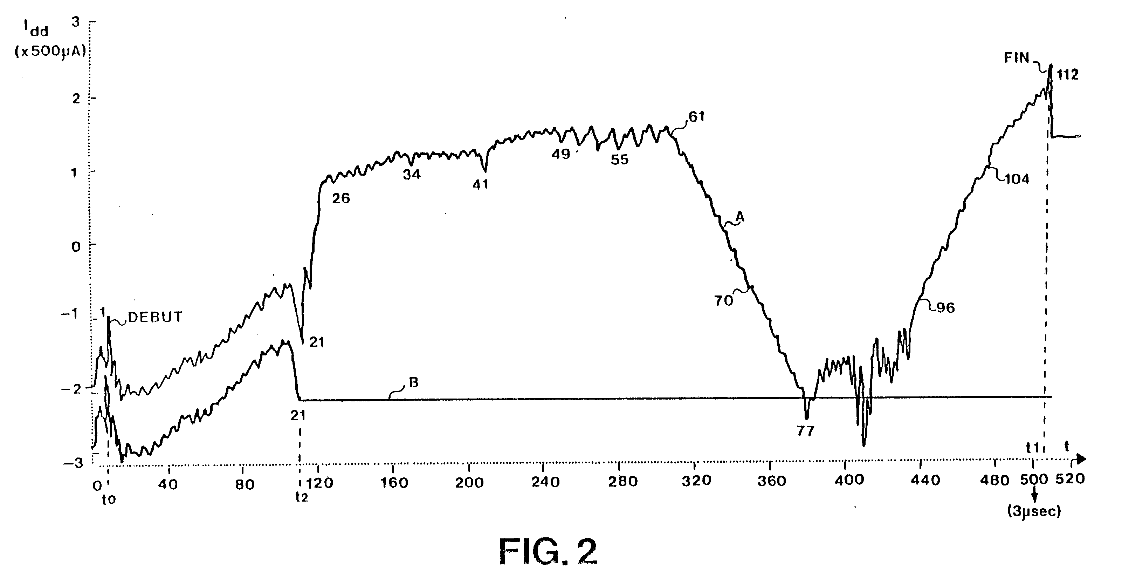

Enfin, on effectue le test fonctionnel proprement dit qui met en œuvre le mode SCAN. Schématiquement, on procède de la façon suivante : un mot de test (série de données binaires) est présenté à l'entrée SDI, on applique alors des impulsions d'horloge sur les entrées A et B pour placer ce mot de test dans les cellules SRL. Toutes les bascules de l'ensemble ayant été ainsi initialisées, des données logiques sont alors présentes sur les sorties parallèles de l'élément fonctionnel. En stimulant les entrées parallèles de l'élément fonctionnel, on peut ensuite par une impulsion d'horloge C, charger dans la chaîne LSSD, un mot binaire reflétant un état de la logique combinatoire. Les sorties sont alors étudiées pour vérifier le fonctionnement de la logique combinatoire, et les résultats obtenus, comparés aux résultats attendus, déterminés par le modèle de simulation (on pourra se référer à la figure 2 dudit article). De cette manière, la logique d'un ensemble fonctionnel est testée de 98 % à 100 %. Ce test fonctionnel est élaboré automatiquement à l'aide d'un programme spécialisé.

Dans la pratique, avant le FLUSH test, on procède tout d'abord à un test paramétrique qui consiste dans la vérification de certaines grandeurs analogiques (courant consommé, courants de fuite, etc...).

Ces tests FLUSH et SCAN ont donc pour objet de vérifier la bonne fonctionnalité des chaînes LSSD. Si ces chaînes sont reconnues bonnes, le test peut se poursuivre, on passe alors au test fonctionnel de la logique combinatoire proprement dite. Il est clair que le test fonctionnel suppose par hypothèse que les chaînes sont sans défaut, par exemple, que les bascules sont opérationnelles, qu'il n'y a pas de court circuits ou de circuits ouverts dans les connections entre les bascules, ou dans les réseaux de distribution des signaux d'horloges.

Parce qu'on a vu ci-dessus que les chaînes pouvaient occuper jusqu'à 40 % de la surface de la microplaquette, la probabilité qu'elles comportent au moins un défaut en fiabilité, est loin d'être négligeable. En outre, les chaînes LSSD comportent habituellement de 20 à 250 cellules. Les cellules sont disposées de façon dispersée sur la surface de la microplaquette, et il est donc pratiquement impossible, tant pour les services méthodes des lignes de fabrication, que pour les services d'analyse de défaut, d'identifier rapidement la cellule défectueuse afin de déterminer la nature du défaut, et de proposer sa correction avec un temps de réponse minimum.

Les tests connus de type FLUSH ou SCAN (qui sont décrits explicitement ou implicitement dans les références Berglund et Williams sus mentionnées), ne peuvent donc que donner des indications globales du genre : la chaîne est bonne ou elle est mauvaise. Ils procèdent par une technique d'analyses de signatures représentées par des mots binaires. Si la chaîne est reconnue mauvaise, il n'y a aucun moyen connu à ce jour pour identifier la (ou les) cellule(s) défectueuse(s) dans la chaîne, et l'élément fonctionnel est éliminé dans sa totalité.

Le fabricant de circuits mettant en œuvre la technique LSSD ressent donc aujourd'hui clairement le besoin d'une technique de test supplémentaire, plus précise que celles connues sous le nom de FLUSH test ou SCAN test, qui identifie avec précision la cellule défectueuse, afin qu'il puisse apporter les corrections nécessaires au niveau des étapes de traitement. Par exemple si des microplaquettes provenant de tranches différentes, présentent la caractéristique d'avoir la même cellule défectueuse, c'est probablement un des masques de lithographie utilisés dans la fabrication de ces tranches qui en est la cause et qui présente un défaut au niveau de cette cellule.

Il ressent également le besoin de faire cette identification, quel que soit l'élément fonctionnel en cause : microplaquette, module... D'autre part, il souhaite enfin qu'elle soit simple, précise et peu coûteuse.

Dans son principe le plus général, l'objet principal de la présente invention telle qu'elle est revendiquée est de remédier aux inconvénients et à l'imprécision des procédés de l'art antérieur en proposant d'abord un procédé de diagnostic électrique qui permet d'identifier une cellule défectueuse dans un registre à décalage constitué de bascules statiques munies d'au moins deux entrées « horloge », ou pouvant fonctionner dans le mode FLUSH précédemment décrit.

3

Pratiquement, la présente invention concerne essentiellement un procédé de diagnostic électrique, pour identifier le rang P d'une cellule défectueuse dans une chaîne de N cellules d'un registre à décalage formant une chaîne LSSD, chaque cellule étant constituée par une bascule statique du type maître-esclave ; une telle cellule comporte une bascule maître L1 munie de ses entrées données DI, SDI et horloge A, C, et une bascule esclave L2 munie de son entrée horloge B. La chaîne est associée à des blocs de logique combinatoire selon la technique LSSD, et intégrée dans un élément fonctionnel déterminé. Dans son principe le procédé de la présente invention consiste dans l'analyse de la signature analogique de l'élément fonctionnel, c'est-à-dire dans l'analyse des variations du courant d'alimentation $I_{dd}$ de l'élément fonctionnel placé dans des conditions de fonctionnement statique au niveau des horloges. Ce procédé est caractérisé en ce qu'il comporte les étapes suivantes :

a) la mise dudit élément fonctionnel défectueux dans un mode statique tel que le mode FLUSH : c'est-à-dire, A = 1, B = 1, C = 0 et application d'une donnée sous la forme d'une impulsion carrée sur l'entrée SDI,

b) la visualisation des variations du courant d'alimentation $I_{dd}$ de l'élément fonctionnel dues à la propagation de ladite donnée, le long de la chaîne, jusqu'à ce qu'elle atteigne la sortie SDO, c'est-à-dire sa signature analogique,

c) la détection d'une variation de courant nulle ($I_{dd}$ = constant) indiquant que la cellule qui vient d'être chargée par ladite donnée, est défectueuse et,

d) la détermination du rang P de cette cellule.

Dans un mode de réalisation préféré, cette détermination peut résulter de la comparaison desdites variations de courant avec celle d'un élément fonctionnel de référence préalablement reconnu bon et étalonné.

Dans un autre mode de réalisation préféré, cette détermination s'effectue à l'aide d'un équipement de test qui fournit le rang P par lecture directe sur un dispositif d'affichage.

La présente invention sera mieux comprise à la lecture de la description qui suit, faite en relation avec les dessins ci-joints dans lesquels :

La figure 1 représente schématiquement les variations du courant d'alimentation $I_{dd}$ d'un élément fonctionnel en mode FLUSH quand une impulsion de forme carrée est appliquée à son entrée SDI.

La figure 2 représente les variations du courant d'alimentation $I_{dd}$ de deux éléments fonctionnels réels et identiques, l'un ayant une chaîne LSSD opérationnelle, l'autre présentant une cellule défectueuse dans sa chaîne LSSD.

La figure 3 représente un équipement de test simplifié pour une détermination manuelle du rang P de la cellule défectueuse selon un premier mode de réalisation.

La figure 4 représente les chronogrammes des impulsions aux bornes d'un élément fonctionnel bon dans un second mode de réalisation.

La figure 5 représente schématiquement un autre équipement de test plus élaboré, sous forme de blocs diagrammes qui permet la détermination rapide du rang P de la cellule défectueuse, selon ledit second mode de réalisation.

La figure 6 représente le détail de réalisation des différents blocs de l'équipement de test montré sur la figure 5.

## Principe de fonctionnement

Chaque chaîne LSSD d'un élément fonctionnel à diagnostiquer (qui peut en comporter plusieurs), est placée dans le mode FLUSH, c'est-à-dire que les horloges A, B et C sont aux niveaux logiques respectifs 1, 1 et 0 tandis qu'une impulsion de donnée, de forme carrée, est appliquée sur l'entrée SDI. Cette impulsion sera donc transmise à la sortie SDO avec un délai égal à la somme des délais de propagation de toutes les N cellules constituant la chaîne. La propagation de cette impulsion induit des commutations dans chacune des cellules, mais également dans le bloc de logique combinatoire (portes logiques, PLA, réseaux logiques, ...), qui lui est associé.

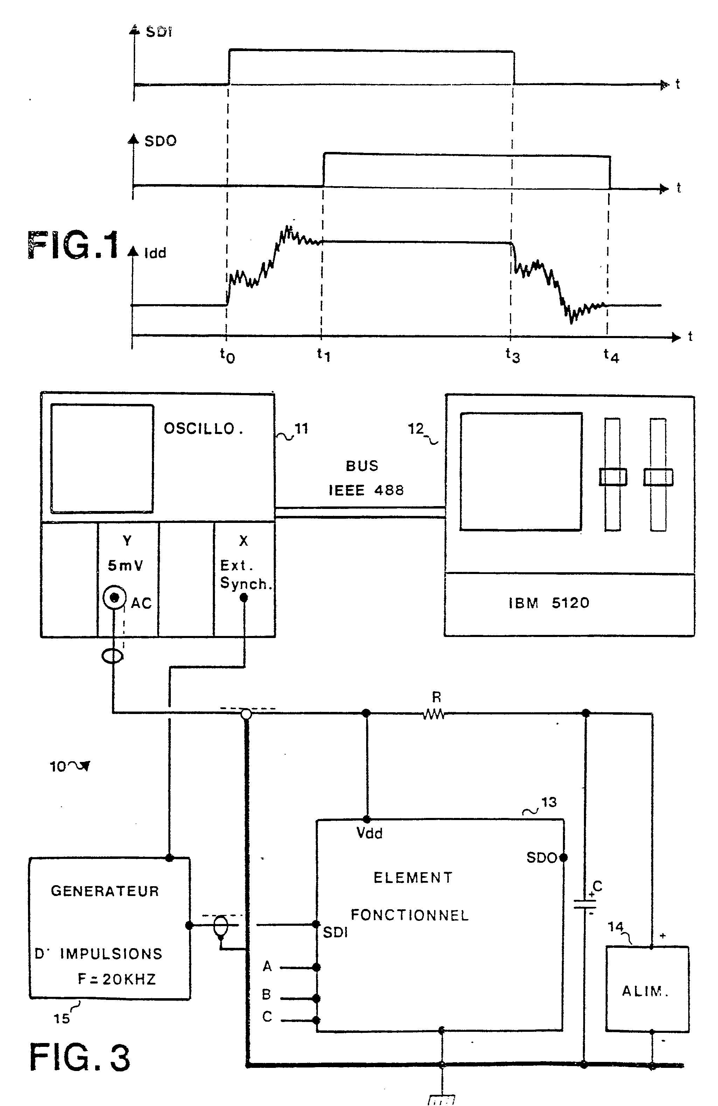

La demanderesse s'est aperçue qu'en visualisant sur un oscilloscope, le courant d'alimentation $I_{dd}$ dudit élément fonctionnel en fonction du temps, on pouvait observer des variations rapides dans le tracé, tant que le flanc montant de l'impulsion appliquée sur l'entrée SDI (à l'instant $t_0$) n'avait pas atteint la sortie SDO (à l'instant $t_1$), c'est-à-dire pendant l'intervalle de temps $\Delta t = t_1 - t_0$. Cela ressort de la figure 1 qui représente schématiquement le chronogramme des différentes impulsions et surtout la forme caractéristique du courant d'alimentation $I_{dd}$ et plus particulièrement de ses variations. On appellera désormais « signature », le signal analogique représentant les variations du courant d'alimentation $I_{dd}$. On remarquera sur la figure 1, qu'entre les instants $t_3$ (retombée de SDI) et $t_4$ (le flanc descendant de SDI atteint la sortie SDO), c'est-à-dire pendant le même intervalle de temps $\Delta t$, on obtient une forme de signature inversée par rapport à celle représentée entre $t_0$ et $t_1$.

Il a été constaté que l'amplitude des pics observés était essentiellement fonction du type de bascule utilisé et de la charge capacitive de sa sortie. Ces pics sont provoqués par un bref appel de courant, lors du changement d'état logique de chaque étage de la chaîne.

Par contre, pour une chaîne déterminée, quand le flanc montant de l'impulsion de donnée arrive sur une cellule défectueuse, la propagation de la donnée est arrêtée et le courant d'alimentation $I_{dd}$ reste constant et égal à sa dernière valeur. La signature présente donc la caractéristique intéressante d'être un segment de droite à partir de cette cellule. La figure 2 représente la signature, référencée par la lettre A, du courant d'alimentation $I_{dd}$ d'un élément fonctionnel réel durant le test FLUSH d'une chaîne de registres. L'impulsion appliquée sur la borne d'entrée atteignant la borne de sortie, cette chaîne a été reconnue bonne. On remarque sur la figure 2, les formes caractéristiques du pic de début à l'instant $t_0$ indiquant le début des commutations et du pic de fin, à l'instant $t_1$, indiquant la fin des commutations. La figure 2 représente également la signature, référencée par la lettre B, d'une chaîne correspondante à un autre élément fonctionnel réel identique au premier, mais dont la cellule de rang 21 est défectueuse. Après que cette cellule, ait été chargée à l'instant $t_2$, il n'y a plus de modification du courant d'alimentation $I_{dd}$ qui demeure donc constant.

## Premier mode de réalisation

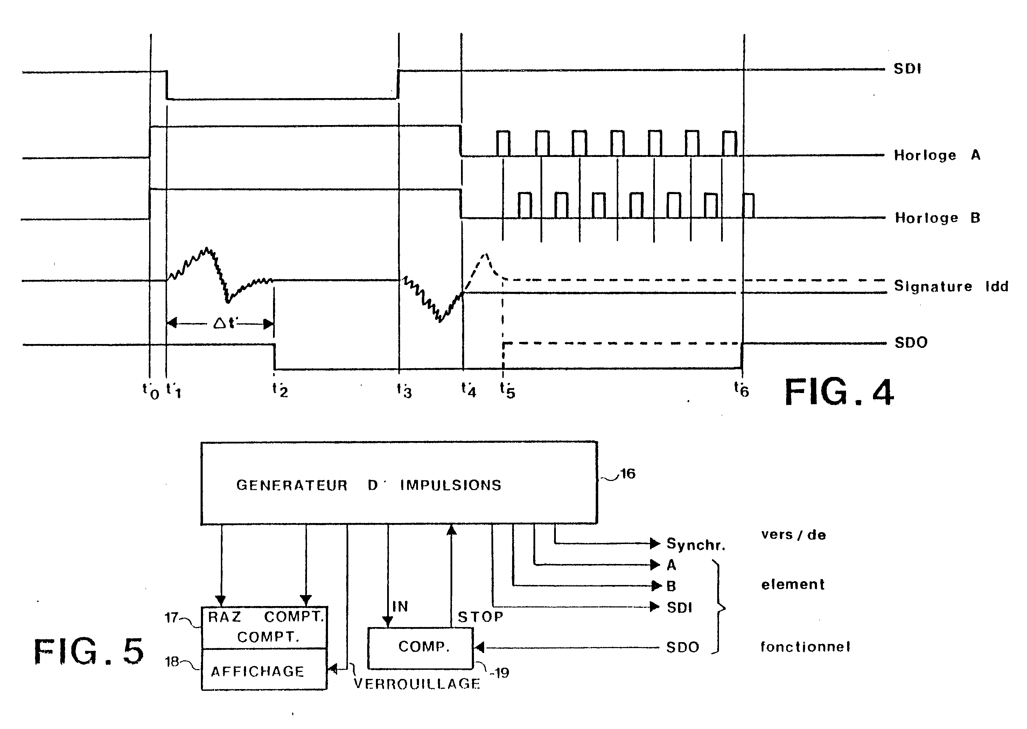

Dans un premier mode de réalisation, l'équipement 10 représenté sur la figure 3 est très simple. Il comporte tout d'abord un oscilloscope à mémoire digitale 11 du type Textronix 7854 muni de l'interface scientifique IEEE 488. Cet appareil est connecté à un calculateur 12, ici un ordinateur IBM 5120 qui mémorise dans une disquette les courbes de références correspondant aux différents types d'éléments fonctionnels à tester, qui doivent être visualisées. L'élément fonctionnel, par exemple un module 13 muni de broches est monté sur un support approprié. Il est alimenté en courant à partir d'une alimentation 14 et d'une résistance R en série (de l'ordre de quelques ohms) reliée à la broche alimentation du $V_{dd}$. Un condensateur C (de l'ordre d'une centaine de μF) est disposé en parallèle avec l'alimentation, afin de réduire le bruit propre en provenance de l'équipement de test. Les broches du module qui correspondent aux entrées des horloges A, B et C, sont convenablement polarisées pour que le module fonctionne dans le mode FLUSH. Chaque chaîne LSSD du module sera successivement testée. La broche SDI est reliée à un générateur d'impulsions carrées (fréquence 20 KHz environ) 15 qui synchronise également l'oscilloscope (sortie synchro). La broche $V_{dd}$ est également reliée à une borne de l'amplificateur Y de l'oscilloscope, avec un câble coaxial aussi court que possible pour réduire l'atténuation qui se produirait inévitablement sur les pics de courant. De façon générale toutes les connections seront faites avec des câbles blindés et les connections de masse seront faites aussi larges que possible. Les broches de sortie du module seront laissées flottantes (si elles correspondent en technologies FET, à des régions drains en circuit ouvert) ou haute impédance (si elles correspondent à des circuits logiques trois états), pour éviter l'influence des bruits de commutation des circuits de sortie en puissance, sur la signature. Pour chaque chaîne, la signature du module de référence et celle du module en cours de test sont affichées simultanément sur l'écran de l'oscilloscope (voir figure 2). Cet équipement permet de connaître l'instant $t_2$, qui est l'instant où se produit le défaut.

Il suffit pour déterminer le rang P de compter le nombre de pics de courant pendant l'intervalle de temps $t_2 - t_0$. On effectuera de préférence l'étalonnage de la signature de référence, avant de procéder par comparaison entre les deux signatures.

L'étalonnage précis de la courbe de référence peut être obtenu en analysant la signature au regard de la composition de la chaîne. Si l'on reconnaît dans la signature des fragments typiques d'un certain type de bascule (par exemple, des bascules fortement chargées du point de vue capacitif, ou qui induisent, en plus du pic de courant, un changement notable de la valeur du courant d'alimentation), on peut identifier et référencer certaines cellules. C'est ce qui explique la présence de la numérotation sur la courbe de référence A de la figure 2.

Une autre façon approximative d'opérer consiste à calculer le rang P de la cellule défectueuse par la relation suivante :

$$P = Nx(t_2 - t_0)/(t_1 - t_0)$$

N est le nombre total de cellules dans la chaîne ;
$t_1 - t_0$ = est le temps nécessaire à une information pour traverser toute la chaîne ;
$t_2$ est l'instant où se produit le défaut.

La pratique montre que dans ce cas, la détermination du rang P se fait à une ou deux cellules près. Cela s'explique par le fait que les délais des différentes cellules composant la chaîne ne sont pas rigoureusement égaux, ils dépendent des caractéristiques des cellules, du câblage des entrées, des charges, etc... Cependant, ces délais peuvent être calculés avec précision, et un programme informatique peut fournir le calcul précis du rang P.

Enfin, le procédé de la présente invention peut dans certaines conditions, notamment quand l'élément fonctionnel analysé est une microplaquette, fournir des indications immédiates précises sur la nature du défaut, en particulier s'il s'agit d'un court-circuit entre deux conducteurs ou d'un circuit ouvert dans un conducteur. Ces deux types de défauts de la métallisation représentent la grande majorité des pannes relevées.

Avec une chaîne LSSD constituée par des paires de bascules classiques du type maître-esclave en

5

technologie FET, on fait les observations suivantes. Quand le défaut est un circuit ouvert entre les deux bascules, la signature devient plate instantanément au niveau de la cellule défectueuse. Quand le défaut est un court-circuit entre un conducteur LSSD et un autre conducteur, un pic de courant se produit avant que la signature ne devienne plate. En effet, le conducteur LSSD est relié à un conducteur qui hésite entre les niveaux 1 et 0, un conflit de niveau apparaît avant/après le front avant de l'impulsion de donnée $(0 \rightarrow 1)$, le courant d'alimentation décroît/croît soudainement à cet instant. Enfin, quand un défaut (circuit ouvert ou court-circuit) se produit sur les conducteurs d'horloge, la bascule concernée, se comporte comme s'il y avait un circuit ouvert et on se retrouve dans le premier cas, la signature devient plate sans pics de courant supplémentaire.

Une fois la cellule défectueuse identifiée, et le type de défaut connu d'après ce qui vient d'être dit, on peut alors localiser facilement physiquement le défaut. S'il s'agit d'un court-circuit, on observera la cellule au microscope, s'il s'agit d'un circuit ouvert, on utilisera plutôt un microscope à balayage électronique pour observer l'ensemble du chemin LSSD et d'horloge.

### Deuxième mode de réalisation

Dans ce deuxième mode de réalisation, l'équipement de test est identique au premier à l'exception du générateur d'impulsions 15 qui est remplacé par un générateur d'impulsions plus complexe associé à un dispositif automatique d'affichage comme on le verra ci-après.

On procède d'abord comme précédemment pour diagnostiquer un module défectueux. Quand une chaîne d'un tel module 13 est reconnue défectueuse, dans un test FLUSH, la signature de cette chaîne défectueuse est alors mise en mémoire dans l'oscilloscope 11. On retire le module défectueux 13 et on le remplace par un module identique 13', reconnu bon. On va faire coïncider la signature de la chaîne correspondante avec celle préalablement stockée et qui reste visualisée sur l'écran de l'oscilloscope. Pour cela, on place le module bon 13' en mode FLUSH. Les signaux d'horloge A et B sont mis au niveau 1, à l'instant $t'_0$ comme cela est représenté sur la figure 4 ; puis, à $t'_1$ on applique une impulsion carrée sur l'entrée SDI de la chaîne correspondante. A l'instant $t'_2$, après un intervalle de temps $\Delta t'$, le flanc descendant du signal SDI atteint la sortie SDO. On retrouve bien la forme caractéristique de la signature d'une chaîne fonctionnelle entre les instants $t'_1$ et $t'_2$ sur la sortie $I_{dd}$. On a chargé toutes les cellules avec des 0 grâce au mode FLUSH.

L'instant $t'_3$, correspond à la fin de l'impulsion carrée appliquée sur SDI. Si après cet instant $t'_3$, le module 13' continuait d'être placé dans le mode FLUSH, on obtiendrait une signature identique, mais inversée, comparée à celle obtenue dans l'intervalle de temps $\Delta t' = t'_2 - t'_1$, et ce conformément aux enseignements de la figure 1. Cette signature s'achèverait à l'instant $t'_5$ qui correspondrait au changement de niveau normal de la sortie SDO qui passerait à 1 après un intervalle de temps identique $\Delta t' = t'_5 - t'_3$.

Le balayage de l'oscilloscope est réglé pour que cette signature vienne se superposer à celle du module défectueux, sur l'écran.

On modifie alors la largeur des impulsions des horloges A et B pour que le module bon, ne reste dans le mode FLUSH que pour afficher sa portion de signature identique à celle du module défectueux. Sur la figure 4, le module bon ne reste dans le mode FLUSH qu'entre les instants $t'_3$ et $t'_4$. C'est-à-dire jusqu'à ce que la cellule qui a le même rang P que celui de la cellule défectueuse, soit chargée. L'intervalle de temps $\Delta T = t'_4 - t'_3$ doit donc être variable et ajustable pour pouvoir s'adapter à différentes longueurs de chaînes $(1 \leqslant P \leqslant N)$.

Pour arrêter le mode FLUSH, à l'instant $t'_4$, on impose un niveau bas aux signaux d'horloge A et B et on se trouve alors dans le mode SCAN. En rendant les horloges A et B inactives, on a arrêté la progression de l'information dans la chaîne de cellules du module bon au rang correspondant, précisément à celui de la cellule défectueuse dans le module défectueux.

Il suffit alors de faire progresser l'information jusqu'à la sortie de la chaîne : le nombre de couples d'impulsions d'horloge, nécessaires pour faire basculer la sortie SDO fournit directement l'indication sur le nombre (N-P) d'étages compris entre le rang de la cellule défectueuse et la fin de la chaîne. On en déduit alors facilement le rang P de la cellule défectueuse. Cela ressort clairement de la figure 4. On a vu que le module bon était placé en mode FLUSH jusqu'à l'instant $t'_4$. Entre les instants $t'_3$ et $t'_4$, il y aura identité entre les deux signatures superposées sur l'écran. Après $t'_4$, si le test avait été prolongé en mode FLUSH, on aurait obtenu la signature représentée en pointillés avec le changement du niveau de sortie SDO prévisible à l'instant $t'_5$, mais on a vu qu'à l'instant $t'_4$, le module bon avait été placé en mode SCAN, d'où la forme de signature ou trait plein représentée sur la figure 4.

A partir de l'instant $t'_4$, on voit qu'il a fallu appliquer sept couples d'impulsions d'horloge A et B pour qu'à l'instant $t'_6$, la sortie SDO change d'état et passe à 1. La chaîne du module bon est alors chargée complètement avec des 1. Le rang de la cellule défectueuse est donc tel que la cellule défectueuse est la septième en commençant par la dernière.

Les niveaux de tension et de courant des impulsions montrées sur la figure 4 sont ceux de la logique TTL standard.

Il est à noter qu'il existe différentes façons de réaliser un équipement de test approprié, notamment par l'utilisation d'un microprocesseur, pour que soit appliqué le séquencement d'impulsions montré sur la figure 4.

Sur la figure 5, on a représenté schématiquement le bloc diagramme d'un équipement de test conforme au deuxième mode de réalisation. Il comprend un générateur d'impulsions 16 qui fournit sur les sorties le signal SYNCHRO pour la synchronisation de l'oscilloscoppe 11, les signaux d'horloge A et B (en modes FLUSH et SCAN, l'horloge système C reste constamment à 0) et le signal de forme carrée qui doit être appliqué sur l'entrée SDI de la chaîne en cours de test. Un compteur 17 compte le nombre de paires d'impulsions à partir du moment où on passe du mode FLUSH en mode SCAN jusqu'au moment du changement d'état sur la borne de sortie SDO, le nombre obtenu (qui représente N-P) est affiché sur les compteurs hexadécimaux 18. Un comparateur 19 détecte le changement d'état sur SDO et retourne un signal STOP vers le générateur d'impulsions. A la réception de ce signal, le générateur vient bloquer l'opération de comptage.

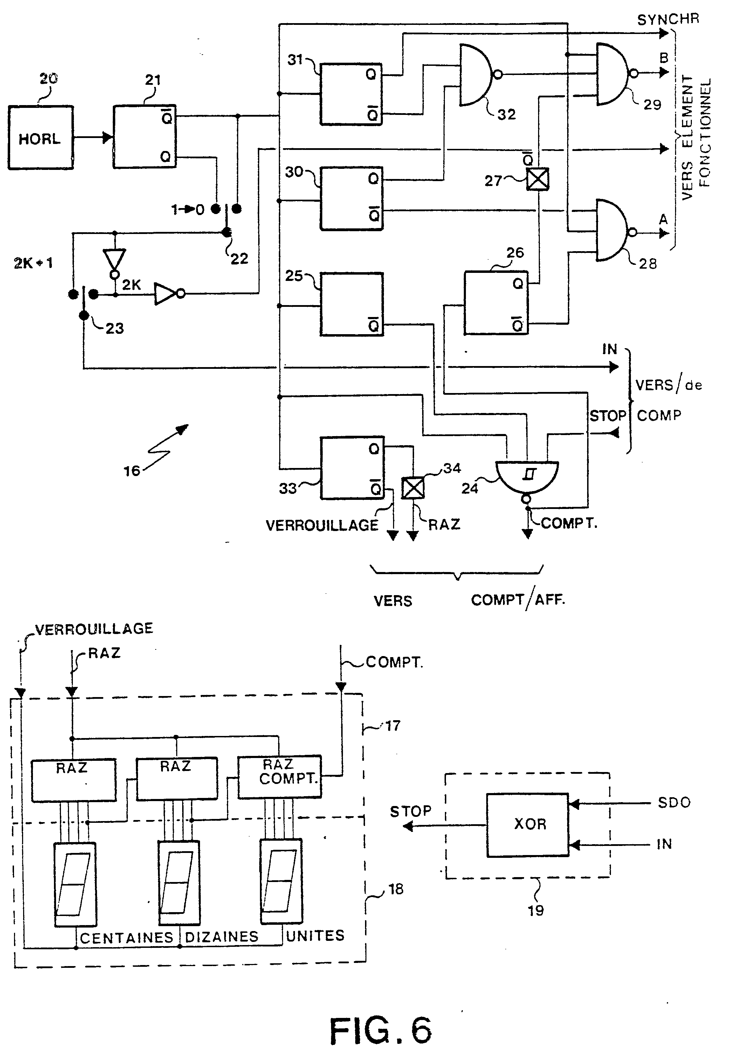

Le détail de cet équipement est montré sur la figure 6. Une horloge maîtresse 20 à 4 KHz qui pilote l'ensemble de l'équipement attaque un monostable 21 (8 μsec) dont les sorties Q et Q̄ peuvent être sélectées par le commutateur 22. Ce commutateur permet de choisir la polarité du signal appliqué sur SDI. Un autre commutateur 23 permet d'inverser ou non le signal selon que la chaîne comporte un nombre pair ou impair de cellules. Le signal IN (IN correspond à SDI ou à son inverse) disponible sur le point commun du commutateur 23 est appliqué sur la première entrée d'un comparateur 19 (qui est en fait un circuit XOR) tandis que la deuxième entrée reçoit le signal issu de la borne SDO. La sortie du comparateur fournit le signal STOP. Ce comparateur 19 compare les signaux SDI et SDO pour détecter le changement d'état de SDO. Une autre horloge 24 à 2 MHz (un trigger de Schmidtt) reçoit le signal d'horloge à travers un monostable 25, mais aussi directement. Il reçoit en outre le signal STOP. Cette horloge 24 sert à piloter différents monostables pour fabriquer les horloges A et B et à attaquer l'entrée « comptage » des compteurs 17. Les monostables 26 et 27 permettent d'attaquer les portes NAND 28 et 29 en fournissant les impulsions des horloges A et B, décalées l'une de l'autre, d'un délai déterminé et de largeurs calibrées, notamment pendant le mode SCAN (après $t'_4$). La durée du mode FLUSH, donc comprise entre les instants $t'_3$ et $t'_4$ est commandée par le monostable 30 grâce à la résistance variable R1. C'est ce qui permet à l'opérateur d'arrêter la signature de l'élément bon à l'emplacement exact de la cellule défectueuse pour obtenir sur l'écran la superposition des seules portions identiques des deux signatures du module défectueux et du module bon. Le passage du mode FLUSH ou mode SCAN est réalisé automatiquement, après un certain délai provoqué par le monostable 25. Le monostable 31 génère l'impulsion de synchronisation pour l'oscilloscope tandis que la porte 32 facultative apporte une temporisation en cas de fluctuations des signaux. La sortie Q̄ du monostable 33 assure le verrouillage des bascules internes des dispositifs d'affichage 18 (fabriqués par Hewlett Packard), et sa sortie Q attaque un monostable 33 qui fournit le signal RAZ de remise à zéro des compteurs 17.

**Revendications**

1. Procédé de diagnostic électrique pour identifier le rang P d'une cellule défectueuse dans une chaîne de N cellules d'un registre à décalage formant une chaîne LSSD, d'un élément fonctionnel, chaque cellule étant constituée par une bascule bistable du type maître-esclave ; une telle cellule étant du genre comportant une bascule maître L1 munie de ses entrées données DI, SDI et horloge A, C et une bascule esclave L2 munie de son entrée horloge B, chaque cellule étant associée de façon connue à un bloc de logique combinatoire, selon la technique LSSD ; ce procédé étant caractérisé par les étapes suivantes :

a) la mise dudit élément fonctionnel défectueux dans un mode statique tel que le mode FLUSH : c'est-à-dire, A = 1, B = 1, C = 0 et application d'une donnée sous la forme d'une impulsion carrée sur l'entrée SDI,

b) la visualisation des variations du courant d'alimentation $I_{dd}$ de l'élément fonctionnel dues à la propagation de ladite donnée, le long de la chaîne, jusqu'à ce qu'elle atteigne la sortie SDO, c'est-à-dire sa signature analogique,

c) la détection d'une variation de courant nulle ($I_{dd}$ = constant) indiquant que la cellule qui vient d'être chargée par ladite donnée, est défectueuse et,

d) la détermination du rang P de cette cellule à l'aide de la position relative de l'instant de la détection de ladite variation de courant nulle par rapport au début ou à la fin de la signature analogique.

2. Procédé selon la revendication 1, caractérisé en ce que ladite étape b) de visualisation consiste à afficher la signature sur l'écran d'un oscilloscope à mémoire digitale.

3. Procédé selon la revendication 2, caractérisé en ce que l'étape d) de détermination consiste à compter le nombre de pics de courant jusqu'à la variation de courant nulle.

4. Procédé selon la revendication 2 en ce que l'étape de détermination d) consiste à calculer :

$$P = Nx(t_2 - t_0)/(t_1 - t_0)$$

où $t_1 - t_0$ est l'intervalle de temps qui serait nécessaire à une information pour traverser toute la chaîne et $t_2 - t_0$, l'intervalle de temps durant lequel la variation de courant $I_{dd}$ n'est pas nulle.

5. Procédé selon la revendication 2, caractérisé en ce que les étapes c) et d) sont remplacées par les étapes suivantes :

e) mise d'un élément fonctionnel reconnu bon dans son mode statique tel que le mode FLUSH : c'est-à-dire A = 1, B = 1, C = 0 et application d'une donnée sous la forme d'une impulsion carrée sur l'entrée SDI,

f) visualisation des variations du courant d'alimentation $I_{dd}$ de cet élément fonctionnel dues à la propagation de ladite donnée le. long de la chaîne, c'est-à-dire sa signature analogique et superposition avec celle de l'élément fonctionnel défectueux,

g) réduction du temps de FLUSH pour que la signature analogique de l'élément fonctionnel bon soit arrêtée à l'emplacement de la variation de courant nulle ($I_{dd}$ = constant) de la signature analogique de l'élément fonctionnel défectueux,

h) mise dudit élément fonctionnel bon en mode SCAN : c'est-à-dire que l'horloge C est maintenue à 0, pendant que l'on applique aux bornes A et B, une série d'impulsions et comptage du nombre de paires d'impulsions d'horloge A et B nécessaires pour obtenir un changement d'état de sa sortie SDO, ce nombre étant égal à N-P,

i) détermination du nombre P à l'aide dudit nombre de paires d'impulsions.

6. Procédé selon l'une des revendications 1 à 5, caractérisé en ce que l'élément fonctionnel est soit une microplaquette de circuits intégrés soit un module électronique.

## Claims

1. An electric diagnostic method of identifying the rank P of a faulty cell in a chain of N cells of a shift register forming a LSSD chain in a functional element, each cell consisting of a latch of the master-slave type ; such a cell being of the type comprising a master latch L1 provided with its data inputs DI, SDI, and clock inputs A, C, and a slave latch L2 provided with its clock input B, each cell being associated in a known manner with a combinatorial logic block in accordance with the LSSD technique, said method being characterized in that it includes the following steps :

a) placing said faulty functional element in a static mode as the FLUSH mode, i. e. A = 1, B = 1, C = 0, and applying a data as a square pulse to the SDI input,

b) monitoring variations in power supply $I_{dd}$ of the functional element due to the propagation of said data along the chain until it reaches the SDO output, i. e. its analog signature,

c) detecting a null variation of the current ($I_{dd}$ = constant) indicating that the cell just loaded is faulty and,

d) determining the rank P of that cell by using the relative position of the instant of detecting said null variation of the current with respect to the beginning or the end of the analog signature.

2. A method according to claim 1, characterized in that said monitoring step b) consists in displaying said signature onto the screen of a digital storage oscilloscope.

3. A method according to claim 2, characterized in that said determining step d) consists in counting the number of peaks of current until the variation of the current becomes null.

4. A method according to claim 2, characterized in that said determining step d) consists in calculating :

$$P = Nx(t_2 - t_0)/(t_1 - t_0)$$

where $t_1 - t_0$ is the time interval that would be required for an information to propagate through all the chain, and $t_2 - t_0$ is the time interval during which the variation of current $I_{dd}$ is not null.

5. A method according to claim 2, characterized in that said steps c) and d) are replaced by the following steps :

e) placing a functional element previously determined as satisfactory in a static mode such as the. FLUSH mode : i. e. A = 1, B = 1, C = 0, and applying a data as a square pulse to the SDI input,

f) monitoring the variations of power supply $I_{dd}$ of said functional element due to the propagation of said data along the chain, i. e. its analog signature, and superimposing with the one of the faulty functional element,

g) reducing the duration of the FLUSH mode so that the analog signature of the satisfactory functional element is stopped at the point of the null variation of the current ($I_{dd}$ = constant) of the analog signature of the faulty functional element,

h) placing said satisfactory functional element in the SCAN mode : i. e. clock C is maintained at 0 while a series of pulses are applied to terminals A and B counting the number of pairs of clock pulses A and B required to obtain a state change at its output SDO, said number being equal to N-P, and

i) determining the value of number P by using said number of pairs of pulses.

6. A method according to any one of claims 1 to 5 characterized in that the functional element is either a printed circuit chip or an electronic module.

## Patentansprüche

8

1. Verfahren einer elektrischen Diagnose, um die Reihe P einer schadhaften Zelle in einer Kette von N-Zellen eines Verschiebungsregisters zu identifizieren, das einen LSSD-Kette eines Funktionselementes bildet, wobei jede Zelle durch ein bistabiles Kipp vom Typ mit Haupt- und Nebenteil gebildet wird ; Zelle vom Typ mit einem Hauptkipp L1 mit seinen Dateneingängen DI, SDI und Taktgeber A, C und einem Nebenkipp L2 mit Takteingang B, wobei jede Zelle auf bekannte Weise nach der LSSD-Technik einem logischen Verknüpfungsblock zugeordnet ist ; dieses Verfahren ist durch folgende Etappen gekennzeichnet :

a) Umschaltung des besagten schadhaften Funktionselementes in einen statischen Zustand wie Betriebsart FLUSH : das heisst $A = 1$, $B = 1$, $C = 0$ und Anlegen eines Datenelementes in Form eines quadratischen Impulses an den Eingang SDI,

b) Anzeige der Schwankungen des Versorgungsstroms $I_{dd}$ des Funktionselementes, die durch die Ausbreitung des besagten Datenelementes bewirkt werden, bis sie den SDO-Ausgang erreicht, das heisst seine Analogsignatur,

c) Detektion einer Stromschwankung Null ($I_{dd}$ = konstant), was anzeigt, dass die mit dem besagten Datenelement belastete Zelle schadhaft ist, und

d) Ermittlung des Reihe P dieser Zelle mit Hilfe der relativen Position des Augenblicks der Detektion der besagten Stromschwankung Null in Bezug auf den Anfang oder das Ende der Analogsignatur.

2. Verfahren gemäss Anspruch 1, dadurch gekennzeichnet, dass die besagte Etappe b) der Anzeige darin besteht, die Natur auf dem Bildschirm eines Oszilloskops mit digitalem Speicher anzuzeigen.

3. Verfahren gemäss Anspruch 2, dadurch gekennzeichnet, dass die Etappe d) der Bestimmung darin, besteht, die Anzahl der Stromspitzen bis zur Stromänderung gleich Null zu zählen.

4. Verfahren gemäss Anspruch 2, dadurch gekennzeichnet, dass die Ermittlungsetappe d) darin besteht, zu berechnen :

$$P = Nx(t_2 - t_0)/(t_1 - t_0)$$

mit $t_1 - t_0$ als Zeitintervall, das für eine Information notwendig wäre, um die ganze Kette zu durchlaufen, und $t_2 - t_0$ als Zeitintervall, in dem die Stromschwankung $I_{dd}$ nicht gleich Null ist.

5. Verfahren gemäss Anspruch 2, dadurch gekennzeichnet, dass die Etappen c) und d) durch folgende Schritte ersetzt werden :

e) Einsetzen eines als fehlerfrei erkannten Funktionselementes in seine statische Betriebsart wie die Betriebsart FLUSH : das heiss $A = 1$, $B = 1$, $C = 0$ und Anlegen eines Datenelementes in Form eines quadratischen Impulses am Eingang SDI,

f) Anzeige der Schwankungen des Versorgungsstroms $I_{dd}$ dieses Funktionselementes durch die Ausbreitung des besagten Datenelements in der Kette, d. h. seiner Analogsignatur und der Überlagerung mit der des schadhaften Funktionselementes,

g) Reduzierung der FLUSH-Zeit, damit die Analogsignatur des einwandfreien Funktionselementes an der Stelle der Stromschwankung gleich Null ($I_{dd}$ = konstant) der Analogsignatur des schadhaften Analogsegmentes angehalten wird,

h) Umschaltung des besagten einwandfreien Funktionselementes in Betriebsart SCAN : das heisst, dass der Taktgeber C auf 0 gehalten wird, während an den Klemmen A und B eine Impulsfolge angelegt wird, und Zählung der Anzahl der Taktimpulse A und B, die notwendig sind, um einen Zustandswechsel seines Ausgangs SDO zu erhalten, wobei diese Zahl gleich N-P ist,

i) Bestimmung der Anzahl P mit Hilfe der besagten Anzahl Impulspaare.

6. Verfahren nach einem der Ansprüche 1 bis 5, dadurch gekennzeichnet, dass das Funktionselement entweder eine Mikroplakette integrierter Schaltungen oder ein Elektronikmodul ist.

**0 146 661**

FIG.1

FIG. 3

FIG. 2

0 146 661

SDI

Horloge A

Horloge B

Signature Idd

SDO

$\Delta t'$

$t'_0$ $t'_1$ $t'_2$ $t'_3$ $t'_4$ $t'_5$ $t'_6$

# FIG. 4

GENERATEUR D' IMPULSIONS — 16

vers / de

Synchr.

A

B — element

SDI

SDO — fonctionnel

17 — RAZ COMPT.

COMPT.

18 — AFFICHAGE

IN

STOP

COMP.

—19

VERROUILLAGE

# FIG. 5

**0 146 661**

FIG.6